# EUROPÄISCHE PATENTSCHRIFT

(11) **EP 1 814 169 B1**
(45) Veröffentlichungstag und Bekanntmachung des Hinweises auf die Patenterteilung: **24.08.2011**
(21) Anmeldenummer: 06124986.8
(22) Anmeldetag: 29.11.2006
(51) Int. Cl.: H01L 41/083, H01L 41/047

(54) **Piezoaktor und Verfahren zur Herstellung desselben**
Piezoelectric actuator and method for producing the same
Actionneur piézo-électrique et procédé de fabrication de celui-ci

(30) Priorität: 31.01.2006 DE 102006004284
(43) Veröffentlichungstag der Anmeldung: 01.08.2007
(73) Patentinhaber: ROBERT BOSCH GMBH, 70442 Stuttgart (DE)
(72) Erfinder: Hohmann, Eugen, 96191 Viereth-Trunstadt (DE); Fergen, Immanuel, 76646 Bruchsal (DE)

(56) Entgegenhaltungen:
- EP-A- 0 844 678
- EP-A- 1 329 915
- WO-A-01/11699
- DE-A1- 19 753 930

## Beschreibung

Die Erfindung betrifft einen Piezoaktor, wie er beispielsweise zur Steuerung von Einspritzanlagen für Brennkraftmaschinen oder als Sensor in einer solchen gebraucht wird und ein Verfahren zur Herstellung des Piezoaktors.

### Stand der Technik

Die Erfindung geht von einem Piezoaktor aus, wie er aus dem Stand der Technik bekannt ist. Ein solcher Piezoaktor ist als Vielschichtaktor ausgebildet und besteht aus einer Vielzahl von piezoaktiven Schichten, die aus einem keramischen Material bestehen. Zwischen den piezoaktiven Schichten ist jeweils eine metallische Innenelektrode ausgebildet, welche abwechselnd an verschiedene Stellen der Oberfläche des Piezoaktors geführt sind. Dort sind die Innenelektroden mit jeweils einer Außenelektrode kontaktiert, die auf die Oberfläche des Piezoaktors aufgebracht ist. Über die Außenelektrode lässt sich eine elektrische Spannung zwischen den Innenelektroden anlegen, sodass die piezoaktive Schicht von einem elektrischen Feld durchdrungen wird. Durch das elektrische Feld wird letztendlich eine Dickenänderung der piezoaktiven Schicht und damit eine Längenänderung des Piezoaktors als Ganzes induziert.

Aus der EP 844 678 B1 ist ein Piezoaktor bekannt, bei dem die Innenelektroden wechselseitig an die Oberfläche des Piezoaktors geführt sind. Auf der Oberfläche des Piezoaktors ist eine Grundmetallisierung aufgebracht, die beispielsweise durch Siebdruck auf die Oberfläche aufgebracht wird, wobei die Grundmetallisierung mit den Innenelektroden elektrisch verbunden ist, die in diesem Bereich an die Oberfläche des Piezoaktors geführt sind. Auf die Grundmetallisierung wird ein Metallschaum aufgebracht, der als Außenelektrode fungiert und der elektrisch mit den Innenelektroden über die Grundmetallisierung verbunden ist. Der Metallschaum weist eine relativ große Flexibilität auf, sodass dieser auch bei einer starken Längenänderung des Piezoaktors intakt bleibt und keine Risse innerhalb der metallschaumförmigen Außenelektrode auftreten. Die Außenelektrode ist ihrerseits mit einem elektrischen Anschluss kontaktiert, über den eine elektrische Spannung angelegt werden kann, die über die Grundmetallisierung letztendlich auch an die Innenelektroden anlegbar ist.

Der bekannte Piezoaktor weist jedoch den Nachteil auf, dass er relativ aufwendig und damit teuer in der Fertigung ist und die metallschaumförmige Außenelektrode darüber hinaus Haftungsprobleme auf der Grundmetallisierung aufweisen kann.

### Offenbarung der Erfindung

Der erfindungsgemäße Piezoaktor mit den kennzeichnenden Merkmalen des Patentanspruchs 1 weist dem gegenüber den Vorteil auf, dass die Außenelektrode einfach und kostengünstig aufgebracht werden kann und die Kontaktierung der Innenelektroden somit in einem einzigen Arbeitsschritt erfolgt. Hierzu wird auf die Oberfläche des Piezoaktors direkt eine metallschaumförmige Außenelektrode aufgebracht, die sich mit der Oberfläche des keramischen Piezoaktors verbindet und so einerseits mechanisch auf der Oberfläche des Piezoaktors haftet und andererseits eine elektrische Kontaktierung zu den Innenelektroden, die in diesem Bereich an die Oberfläche des Piezoaktors geführt sind, herstellt. Diese metallschaumförmige Außenelektrode kann direkt mit einem elektrischen Anschluss versehen werden, sodass die elektrische Spannung ohne weitere Bauteile direkt in diese metallschaumförmige Außenelektrode eingebracht werden kann. Die Außenelektrode kann hierbei vorzugsweise mit der Außenelektrode verlötet werden.

In einer vorteilhaften Ausgestaltung des Gegenstands der Erfindung ist die Außenelektrode aus Silber oder zum überwiegenden Teil aus Silber gefertigt, da Silber sehr gute elektrische Eigenschaften aufweist und im aufgeschäumten Zustand eine gute Flexibilität über den gesamten Temperaturbereich aufweist, der von einem Piezoaktor abgedeckt werden muss, wie er beispielsweise in einer Einspritzeinrichtung einer Brennkraftmaschine verwendet wird.

In einer weiteren vorteilhaften Ausgestaltung wird auf die metallschaumförmige Außenelektrode ein Leitpolymer aufgebracht, das die Poren im Metallschaum füllt. Dadurch ist eine glattere Oberfläche der Außenelektrode gegeben. Sollte die Dehnungsfähigkeit des Metallschaums für den Hub des Aktors dennoch nicht ausreichen und die Gefahr eines Risses gegeben sein, kann darüber hinaus über das Leitpolymer ein Metallgewebe mit der Außenelektrode verbunden werden, wobei das flexible Metallgewebe auch sehr große Hübe des Piezoaktors problemlos verfolgen kann, sodass eine elektrische Spannung, die über das Metallgewebe eingeleitet wird, über das Leitpolymer und die metallschaumförmige Außenelektrode stets einen zuverlässigen elektrischen Kontakt zu den Innenelektroden aufweist.

In einem erfindungsgemäßen Verfahren zum Herstellen eines Piezoaktors, der eine Vielzahl von piezoaktiven Schichten aufweist, wird die Außenelektrode in vorteilhafter Weise durch Flammspritzen auf die Oberfläche des Piezoaktors aufgetragen. Flammspritzen hat hierbei den Vorteil, dass es ein sehr schneller Prozess ist, sodass die Außenelektrode bei den typischen Abmessungen eines Piezoaktors, wie er für den Einsatz in Kraftstoffeinspritzanlagen verwendet wird, in sehr kurzen Taktzeiten von weniger als einer Sekunde aufgebracht werden kann. Durch das Flammspritzen lässt sich beispielsweise Silber problemlos auf die Oberfläche eines keramischen Piezoaktors aufbringen. Der Metallschaum verhakt sich hierbei in der relativ poröse Oberfläche der Keramik, sodass eine sehr gute Haftung der metallschaumförmigen Außenelektrode auf der Oberfläche des Piezoaktors gegeben ist. Die metallschaumförmige Außenelektrode kann anschließend direkt mit einem elektrischen Anschluss versehen werden, über den die elektrische Spannung angelegt wird.

In einer Weiterbildung des Verfahrens wird auf die Außenelektrode eine Schicht aus Leitpolymer aufgebracht und auf diese ein elastisches Metallgeflecht, das durch das Leitpolymer auf der Außenelektrode gehalten wird. Das Metallgeflecht wird anschließend mit einem elektrischen Anschluss verbunden, über den eine elektrische Spannung in das Metallgeflecht und über das Leitpolymer auch in die Außenelektrode und die Innenelektroden anlegbar ist. Durch diesen Vielschichtaufbau ist eine äußerst flexible Außenelektrode gegeben, bei der auch bei großen Hüben nicht die Gefahr besteht, dass der elektrische Kontakt zu einzelnen Innenelektroden unterbrochen wird.

### Zeichnung

In der Zeichnung ist ein erfindungsgemäßer Piezoaktor dargestellt. Es zeigt
- Figur 1: einen erfindungsgemäßen Piezoaktor in einer Seitenansicht,
- Figur 2: ein weiteres Ausführungsbeispiel eines erfindungsgemäßen Piezoaktors,
- Figur 3: einen Schnitt durch einen oberflächennahen Bereich des erfindungsgemäßen Piezoaktors nach Figur 1 und
- Figur 4: ein weiteres Ausführungsbeispiel für eine Außenelektrode in derselben Ansicht wie Figur 3.

### Beschreibung der Ausführungsbeispiele

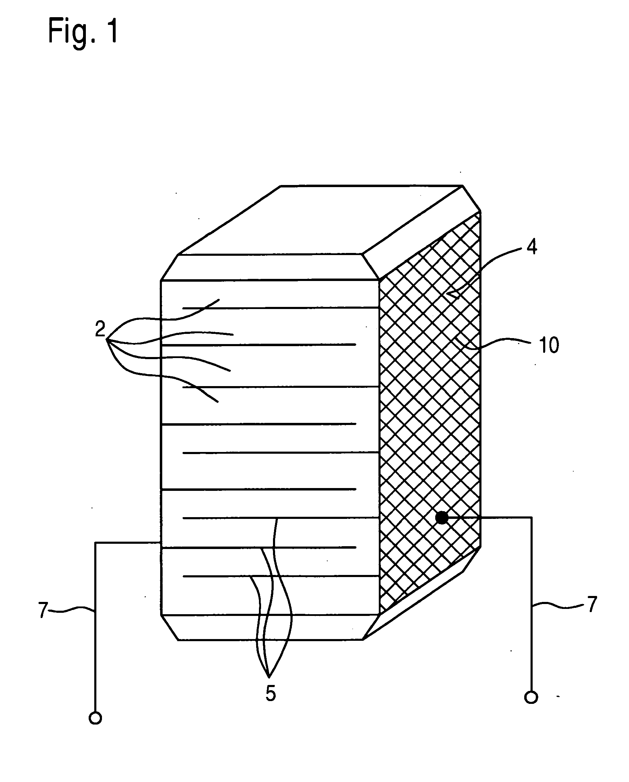

In **Figur 1** ist ein erfindungsgemäßer Piezoaktor in einer Seitenansicht dargestellt, der im wesentlichen eine Quaderform und vier Seitenflächen 4 aufweist. Der Piezoaktor weist eine Vielzahl von piezoaktiven Schichten 2 auf, die aus einem piezoaktiven, keramischen Material bestehen und bei Anlegen einer elektrischen Spannung ihre Dicke ändern. Bei Piezoaktoren, wie sie für die Steuerung in Einspritzanlagen in Brennkraftmaschinen verwendet werden, sind in der Regel 200 solcher Schichten oder auch mehr vorgesehen. Zwischen jeweils zwei benachbarten piezoaktiven Schichten 2 ist eine metallische Innenelektrode 5 angeordnet, die aus einer dünnen Metallschicht besteht, wobei jeweils benachbarte Innenelektroden 5 in diesem Ausführungsbeispiel wechselseitig an die Oberfläche des Piezoaktors geführt sind. Die benachbarten Innenelektroden 5 müssen nicht unbedingt an gegenüber liegenden Seiten des Piezoaktors an die Oberfläche geführt sein, sondern dies kann auch auf derselben Seitenfläche oder in anderer Weise geschehen.

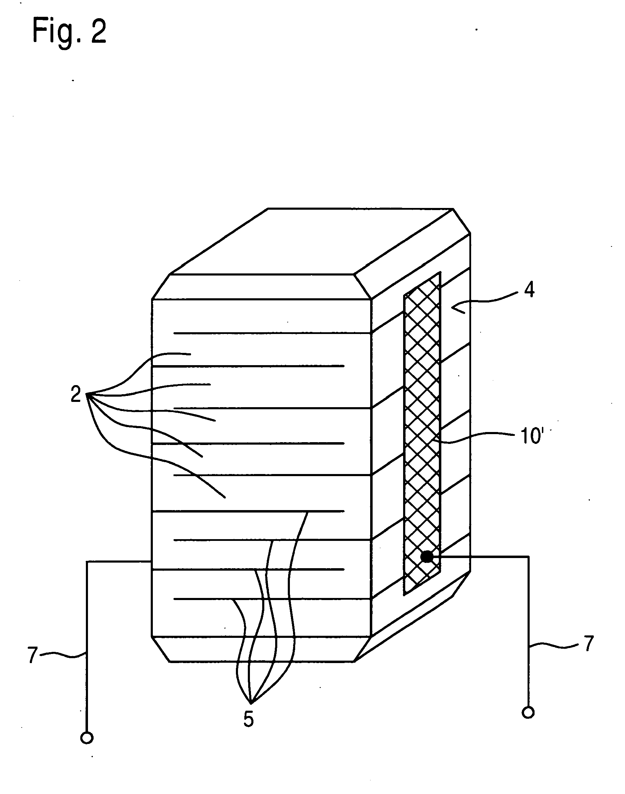

Auf einer Seitenfläche 4 des Piezoaktors ist eine Außenelektrode 10 aufgebracht, die aus einer metallischen Schicht besteht. Die Außenelektrode 10 bedeckt in diesem Ausführungsbeispiel die gesamte Seitenfläche 4 des Piezoaktors und ist mit der Hälfte der Innenelektroden 5 in elektrischem Kontakt. Die Außenelektrode 10 ist mit einem elektrischen Anschluss 7 verbunden, über den eine elektrische Verbindung mit einer Spannungsquelle hergestellt werden kann, sodass eine elektrische Spannung an die Außenelektrode 10 und damit auch an die Hälfte der Innenelektroden 5 anlegbar ist. An der gegenüber liegenden Seite des Piezoaktors ist eine gleichartige Außenelektrode 10 aufgebracht, die ebenfalls mit einem elektrischen Anschluss 7 verbunden ist und die mit der anderen Hälfte der Innenelektroden 5 elektrisch verbunden ist. Durch das Anlegen einer elektrischen Spannung zwischen den beiden elektrischen Anschlüssen 7 entsteht so ein elektrisches Feld zwischen jeweils benachbarten Innenelektroden 5, sodass die piezoaktiven Schichten von einem elektrischen Feld durchdrungen werden und je nach Größe und Ausrichtung des elektrischen Felds ihre Dicke ändern, wodurch der Piezoaktor insgesamt seine Länge ändert. Die Außenelektrode 10 muss hierbei nicht die gesamte Seitenfläche 4 des Piezoaktors bedecken. Wie **Figur 2** zeigt, kann die Außenelektrode 10 auch beispielsweise in einem Streifen, der in der Mitte der Seitenfläche 4 angeordnet ist, ausgebildet sein. Die Form ist beliebig, solange eine elektrische Kontaktierung sämtliche Innenelektroden, die auf die Seitenfläche 4 geführt sind, sichergestellt ist.

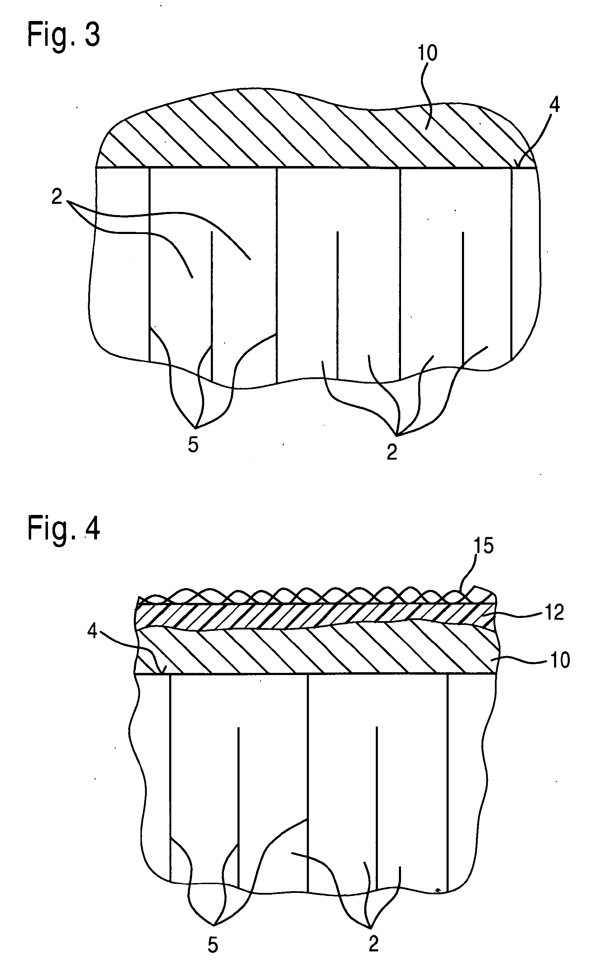

**Figur 3** zeigt einen Querschnitt durch den Piezoaktor nach Figur 1 im Bereich der Oberfläche. Die Außenelektrode 10 ist als aufgebrachter Metallschaum ausgebildet, der direkt auf die keramische Oberfläche des Piezoaktors aufgebracht ist. Da Keramik ein relativ poröses und damit auf mikroskopischer Ebene rauhes Material darstellt, kann sich der Metallschaum gut mit der Oberfläche des Piezoaktors verbinden und haftet damit zuverlässig auf der Oberfläche 4. Sollte die gegebene Rauhigkeit des Piezoaktors nicht ausreichend sein, so kann die Oberfläche auch vor dem Aufbringen der Außenelektrode 10 auf gerauht werden, beispielsweise durch Sandstrahlen oder in einem chemischen Prozess.

Die Außenelektrode 10 ist vorzugsweise aus Silber oder aus einer Legierung mit einem hohen Silberanteil hergestellt, da sich Silber beispielsweise mittels Flammspritzen gut auf die Oberfläche des Piezoaktors aufbringen lässt. Der Metallschaum ist hierbei direkt mit den Innenelektroden 5 verbunden, die in diesem Bereich des Piezoaktors an die Oberfläche geführt sind. Die metallschaumförmige Außenelektrode 10 kann direkt mit einem elektrischen Anschluss 7 versehen werden, sodass der Piezoaktor bereits nach Aufbringen der metallschaumförmigen Außenelektrode 10, was in einem einzigen Arbeitsgang geschieht, fertig ausgebildet ist und nur noch kontaktiert werden muss.

Die so aufgebrachte metallschaumförmige Außenelektrode 10 weist eine sehr hohe Duktilität auf und kann somit der Bewegung des Piezoaktors in der Regel folgen, ohne dass Risse in der metallschaumförmigen Außenelektrode 10 auftreten. Um zusätzlichen Sicherheitsspielraum zu haben oder bei sehr großen Hüben des Piezoaktors kann es darüber hinaus vorgesehen sein, zusätzlich zur metallschaumförmigen Außenelektrode 10 eine Außenelektrode aus einem Metallgeflecht 15 aufzubringen, das mittels eines Leitpolymers 12 auf die Außenelektrode 10 aufgeklebt ist, wie es **Figur 4** zeigt. Hierbei wird nach dem ersten Arbeitsgang, bei dem die Außenelektrode 10 durch Aufspritzen des Metalls auf die Oberfläche des Piezoaktors ausgebildet wurde, das Leitpolymer 12 aufgebracht, das als Kleber für das Metallgeflecht 15 dient. Anschließend wird das Leitpolymer 12 ausgehärtet, sodass eine gute mechanische und elektrische Verbindung des Metallgeflechts 15 mit der Außenelektrode 10 über das elektrische leitende Polymer 12 geschieht.

Das Metallgeflecht 15 kann hierbei als Netz ausgebildet sein, also durch miteinander verwebte Metallfäden, oder auch aus einer ungeordneten Anhäufung von Metallfäden gebildet sein, die eine Art Metallwolle bilden. Das Metallgewebe 15 ist hierbei vorzugsweise aus Invar gebildet, das eine geringe Wärmeausdehnung aufweist und somit geringe mechanische Spannungen zwischen dem Piezoaktor und dem Metallgewebe 15 induziert, wenn sich die Temperatur des Piezoaktors ändert. Der elektrische Anschluss 7 ist bei diesem Ausführungsbeispiel mit dem Metallgewebe 15 verbunden, wie in Figur 4 gezeigt. Dadurch wird die elektrische Spannung über das Metallgewebe 15, das Leitpolymer 12 und die Anschlusselektrode 10 an die Innenelektroden 5 angelegt.

Statt des Leitpolymers 12 kann auch jeder andere elektrisch leitende Kleber verwendet werden, beispielsweise Leitsilber.

## Patentansprüche

1. Piezoaktor mit einer Vielzahl von piezoaktiven Schichten (2), zwischen denen jeweils eine metallische Innenelektrode (5) angeordnet ist, wobei sich die Innenelektroden (5) bis zu einer Oberfläche (4) des Piezoaktors erstrecken, und mit einer Auβenelektrode (10), die auf die Oberfläche (4) des Piezoaktors aufgebracht ist und die einen Teil der Innenelektroden (5) kontaktiert, so dass sich an diese eine elektrische Spannung anlegen lässt, **dadurch gekennzeichnet, dass** die Außenelektrode (10) aus einem Metallschaum besteht, der in direktem elektrischen Kontakt zumindest mit einem Teil der Innenelektroden (5) steht.

2. Piezoaktor nach Anspruch 1, **dadurch gekennzeichnet, dass** die Außenelektrode (10) mit einem elektrischen Anschluss (7) verbunden ist, durch welchen elektrischen Anschluss (7) sich eine elektrische Spannung an die Außenelektrode (10) anlegen lässt.

3. Piezoaktor nach Anspruch 2, **dadurch gekennzeichnet, dass** der elektrische Anschluss (7) mit der Außenelektrode (10) verlötet ist.

4. Piezoaktor nach Anspruch 1, **dadurch gekennzeichnet, dass** die Außenelektrode (10) aus Silber oder zu einem Teil aus Silber besteht.

5. Piezoaktor nach Anspruch 1, **dadurch gekennzeichnet, dass** mehr als eine Außenelektrode (10) auf der Oberfläche (4) des Piezoaktors angeordnet sind, wobei die Außenelektroden (10) gegeneinander elektrisch isoliert sind.

6. Piezoaktor nach einem der Ansprüche 1 bis 5, **dadurch gekennzeichnet, dass** die Auβenelektrode (10) mit einer Schicht aus Leitpolymer (12) beschichtet ist.

7. Piezoaktor nach Anspruch 6, **dadurch gekennzeichnet, dass** auf das Leitpolymer ein Metallgewebe (15) aufgebracht ist, das durch das Leitpolymer (12) mit der aus Metallschaum gebildeten Außenelektrode (10) verbunden ist.

8. Piezoaktor nach Anspruch 7, **dadurch gekennzeichnet, dass** das Metallgewebe (15) ein Netz aus Metalldraht ist.

9. Piezoaktor nach Anspruch 8, **dadurch gekennzeichnet, dass** das Metall Invar ist.

10. Piezoaktor nach Anspruch 6, 7, 8 oder 9, **dadurch gekennzeichnet, dass** das Metallgewebe (15) mit einem elektrischen Anschluss (7) verbunden ist.

11. Verfahren zum Herstellen eines Piezoaktors mit einer Vielzahl von piezoaktiven Schichten (2), zwischen denen jeweils eine metallische Innenelektrode (5) angeordnet ist, wobei sich die Innenelektroden (5) bis zu einer Oberfläche (4) des Piezoaktors erstrecken, und mit einer Außenelektrode (10), die auf der Oberfläche des Piezoaktors angebracht ist und die einen Teil der Innenelektroden (5) kontaktiert, **gekennzeichnet durch** folgenden Verfahrensschritt
- Aufbringen der Außenelektrode (10) **durch** Flammspritzen auf die Oberfläche des Piezoaktors so, dass die Außenelektrode (10) in direktem elektrischen Kontakt mit den Innenelektroden (5) steht.

12. Verfahren nach Anspruch 11, **gekennzeichnet durch** den weiteren Verfahrensschritt
- Kontaktierung der aufgespritzten Außenelektrode (10) **durch** einen elektrischen Anschluss (7), so dass sich eine elektrische Spannung an die Außenelektrode (10) anlegen lässt.

13. Verfahren nach Anspruch 11, **gekennzeichnet durch** die weiteren Verfahrensschritte
- Aufbringen einer Schicht aus Leitpolymer (12) auf die Außenelektrode (10)
- Aufbringen eines Metallgeflechts (15) auf das Leitpolymer (12), so dass das Metallgeflecht (15) **durch** das Leitpolymer (12) auf der Außenelektrode (10) gehalten wird,
- Kontaktierung des Metallgeflechts (15) **durch** einen elektrischen Anschluss (7).

## Claims

1. Piezoelectric actuator, comprising a multiplicity of piezoactive layers (2) between each of which there is a metallic inner electrode (5), wherein the inner electrodes (5) extend as far as a surface (4) of the piezoelectric actuator, and comprising an outer electrode (10), which is applied to the surface (4) of the piezoelectric actuator and which makes contact with a part of the inner electrodes (5), such that an electrical voltage can be applied thereto, **characterized in that** the outer electrode (10) consists of a metal foam which is in direct electrical contact at least with a part of the inner electrodes (5).

2. Piezoelectric actuator according to Claim 1, **characterized in that** the outer electrode (10) is connected to an electrical terminal (7), by means of which electrical terminal (7) an electrical voltage can be applied to the outer electrode (10).

3. Piezoelectric actuator according to Claim 2, **characterized in that** the electrical terminal (7) is soldered to the outer electrode (10).

4. Piezoelectric actuator according to Claim 1, **characterized in that** the outer electrode (10) consists of silver or in part of silver.

5. Piezoelectric actuator according to Claim 1, **characterized in that** more than one outer electrode (10) is arranged on the surface (4) of the piezoelectric actuator, wherein the outer electrodes (10) are electrically insulated with respect to one another.

6. Piezoelectric actuator according to one of Claims 1 to 5, **characterized in that** the outer electrode (10) is coated with a layer of conductive polymer (12).

7. Piezoelectric actuator according to Claim 6, **characterized in that** a woven metal fabric (15) is applied to the conductive polymer and is connected by the conductive polymer (12) to the outer electrode (10) formed from metal foam.

8. Piezoelectric actuator according to Claim 7, **characterized in that** the woven metal fabric (15) is a mesh of metal wire.

9. Piezoelectric actuator according to Claim 8, **characterized in that** the metal is Invar.

10. Piezoelectric actuator according to Claim 6, 7, 8 or 9, **characterized in that** the woven metal fabric (15) is connected to an electrical terminal (7).

11. Method for producing a piezoelectric actuator comprising a multiplicity of piezoactive layers (2) between each of which there is a metallic inner electrode (5), wherein the inner electrodes (5) extend as far as a surface (4) of the piezoelectric actuator, and comprising an outer electrode (10), which is applied to the surface of the piezoelectric actuator and which makes contact with a part of the inner electrodes (5), **characterized by** the following method step:
- the outer electrode (10) is applied to the surface of the piezoelectric actuator by flame spraying, such that the outer electrode (10) is in direct electrical contact with the inner electrodes (5).

12. Method according to Claim 11, **characterized by** the further method step:
- the outer electrode (10) applied by spraying is contact-connected by an electrical terminal (7), such that an electrical voltage can be applied to the outer electrode (10).

13. Method according to Claim 11, **characterized by** the further method steps:
- a layer of conductive polymer (12) is applied to the outer electrode (10),
- a metal mesh (15) is applied to the conductive polymer (12), such that the metal mesh (15) is held by the conductive polymer (12) on the outer electrode (10),
- the metal mesh (15) is contact-connected by an electrical terminal (7).

## Revendications

1. Actionneur piézoélectrique comprenant une pluralité de couches piézoactives (2), entre lesquelles est à chaque fois disposée une électrode interne métallique (5), les électrodes internes (5) s'étendant jusqu'à une surface (4) de l'actionneur piézoélectrique et comprenant une électrode externe (10) qui est appliquée à la surface (4) de l'actionneur piézoélectrique et qui vient en contact avec une partie des électrodes internes (5), de sorte qu'une tension électrique puisse être appliquée à celles-ci, **caractérisé en ce que** l'électrode externe (10) se compose d'une mousse métallique qui est en contact électrique direct au moins avec une partie des électrodes internes (5).

2. Actionneur piézoélectrique selon la revendication 1, **caractérisé en ce que** l'électrode externe (10) est connectée à une borne électrique (7), une tension électrique pouvant être appliquée à l'électrode externe (10) par ladite borne électrique (7).

3. Actionneur piézoélectrique selon la revendication 2, **caractérisé en ce que** la borne électrique (7) est brasée à l'électrode externe (10).

4. Actionneur piézoélectrique selon la revendication 1, **caractérisé en ce que** l'électrode externe (10) se compose d'argent ou en partie d'argent.

5. Actionneur piézoélectrique selon la revendication 1, **caractérisé en ce que** plusieurs électrodes externes (10) sont appliquées sur la surface (4) de l'actionneur piézoélectrique, les électrodes externes (10) étant isolées électriquement les unes par rapport aux autres.

6. Actionneur piézoélectrique selon l'une quelconque des revendications 1 à 5, **caractérisé en ce que** l'électrode externe (10) est revêtue d'une couche en polymère conducteur (12).

7. Actionneur piézoélectrique selon la revendication 6, **caractérisé en ce qu'**un tissu métallique (15) est appliqué sur le polymère conducteur, lequel tissu métallique est connecté par le biais du polymère conducteur (12) à l'électrode externe (10) formée en mousse métallique.

8. Actionneur piézoélectrique selon la revendication 7, **caractérisé en ce que** le tissu métallique (15) est un treillis en fil métallique.

9. Actionneur piézoélectrique selon la revendication 8, **caractérisé en ce que** le métal est de l'Invar.

10. Actionneur piézoélectrique selon la revendication 6, 7, 8 ou 9, **caractérisé en ce que** le tissu métallique (15) est connecté à une borne électrique (7).

11. Procédé de fabrication d'un actionneur piézoélectrique comprenant une pluralité de couches piézoélectriques (2), entre lesquelles est à chaque fois disposée une électrode interne métallique (5), les électrodes internes (5) s'étendant jusqu'à une surface (4) de l'actionneur piézoélectrique, et comprenant une électrode externe (10), qui est appliquée sur la surface de l'actionneur piézoélectrique et qui vient en contact avec une partie des électrodes internes (5), **caractérisé par** l'étape de procédé suivants :
- application de l'électrode externe (10) par projection par flamme sur la surface de l'actionneur piézoélectrique, de sorte que l'électrode externe (10) soit en contact direct avec les électrodes internes (5).

12. Procédé selon la revendication 11, **caractérisé par** l'étape supplémentaire suivants :
- mise en contact de l'électrode externe (10) appliquée par projection avec une borne électrique (7), de sorte qu'une tension électrique puisse être appliquée à l'électrode externe (10).

13. Procédé selon la revendication 11, **caractérisé par** les étapes de procédé supplémentaires suivantes :
- application d'une couche de polymère conducteur (12) sur l'électrode externe (10),
- application d'un maillage métallique (15) sur le polymère conducteur (12), de sorte que le maillage métallique (15) soit maintenu par le polymère conducteur (12) sur l'électrode externe (10),
- mise en contact du maillage métallique (15) avec une borne électrique (7).
